# EUROPÄISCHE PATENTANMELDUNG

(11) **EP 0 902 609 A1**
(43) Veröffentlichungstag der Anmeldung: **17.03.1999**
(21) Anmeldenummer: 97810636.7
(22) Anmeldetag: 05.09.1997
(51) Int. Cl.: H05K 3/00, B32B 31/00, C09J 5/00, C09J 5/06

(54) **Verfahren zum Herstellen einer Leiterplatte, Leiterplatte und Anordnung zum Durchführen des Verfahrens**

(71) Anmelder: Ascom Hasler AG, CH-3000 Bern 14 (CH)
(72) Erfinder: Todt, André, 3052 Zollikofen (CH); Lüscher, Dieter, 3604 Thun (CH); Rappo, Paul, 3186 Düdingen (CH); Weber, Walter, 3184 Wünnewil (CH)
(74) Vertreter: Roshardt, Werner Alfred, Dipl.-Phys.

(57) **Zusammenfassung**

Ein Verfahren zum Herstellen einer mit mindestens einem Kühlkörperteil (20) versehenen Leiterplatte (10) weist folgende Schritte auf: ein dauerelastischer Haftkleber (15) wird auf eine Klebfläche eines ersten Teiles des Teilepaares bestehend aus der Leiterplatte (10) und dem mindestens einen mit dieser zu verbindenden Kühlkörperteil (20) aufgetragen (30); zur Elimination von allfällig im Kleber (15) und/oder zwischen dem Kleber (15) und der Klebfläche vorhandenen Luftblasen wird das erste Teil mitsamt dem aufgetragenen Kleber (15) getempert (35); die Verbindung zwischen den beiden zu verbindenden Teilen des Teilepaares wird hergestellt, indem die Klebfläche des ersten Teiles und die Klebfläche des zweiten Teiles aneinandergedrückt (40) werden.

Eine nach einem solchen Verfahren hergestellte Leiterplatte (10) erfüllt hohe Anforderungen bezüglich elektrischem Isolationsvermögen und Wärmeübertragung zwischen der Leiterplatte (10) und dem Kühlkörperteil (20), Vibrationsfestigkeit, Dilatationsfestigkeit und Langlebigkeit. Dadurch ist sie insbesondere für Anwendungen in Kraftfahrzeugmotoren geeignet ist.

## Beschreibung

### Technisches Gebiet

Die Erfindung betrifft ein Verfahren zum Herstellen einer mit einem Kühlkörperteil versehenen Leiterplatte, eine nach einem solchen Verfahren hergestellte Leiterplatte sowie eine Anordnung zum Durchführen des Verfahrens.

### Stand der Technik

Üblicherweise wird die von elektronischen Bauelementen auf Leiterplatten erzeugte Verlustwärme mittels einer freien oder erzwungenen Luftströmung über die Konvektion abgeführt. Sobald jedoch die Leiterplatten mit integrierten Bausteinen und/oder Leistungsbauelementen bestückt werden, die eine hohe Verlustwärme erzeugen, reicht die Wärmeabfuhr mittels Konvektion häufig nicht mehr aus, um die Bauelemente wirksam vor thermisch erzeugten Schäden zu schützen. Ein Lösungsweg besteht in diesem Falle darin, dass die Leiterplatten mit Kühlkörpern zur Wärmeableitung versehen werden.

Aus US 4 965 699 ist eine einseitig mit elektronischen Bauteile bestückte Leiterplatte bekannt, an deren unbestückter Seite eine Kühlplatte angebracht ist. Die Kühlplatte ist mit Schrauben an der Leiterplatte befestigt. Bei einer Ausführungsform gemäss US 4 965 699 besteht die Kühlplatte aus Aluminium, wobei die gegen die Leiterplatte gerichtete Oberfläche der Kühlplatte eloxiert ist. Durch das Eloxieren entsteht eine wärmeleitende, elektrisch isolierende Oxid-Schicht auf der Aluminiumplatte. Zur Verbesserung der elektrischen Isolation zwischen Kühlplatte und Leiterplatte und zum Zwecke der Stossdämpfung kann zwischen der Kühlplatte und der Leiterplatte zusätzlich eine dünne Zwischenschicht aus einem wärmeleitfähigen, elektrisch isolierenden Silikon-Elastomer angeordnet werden.

In DE 195 19 776 wird ein Verfahren zum Herstellen einer Leiterplatte und eine mit diesem Verfahren hergestellte Leiterplatte beschrieben, wobei auf der Unterseite der Leiterplatte mindestens ein flaches Kühlkörperteil befestigt ist. Das Kühlkörperteil wird entweder mittels Löten oder mittels einer beidseitig klebenden, gut wärmeleitenden Folie an der Leiterplatte befestigt.

Für Anwendungen von mit Kühlkörpern oder Kühlplatten versehenen Leiterplatten in einer Umgebung, die grossen Temperaturänderungen ausgesetzt ist (z.B. in elektronischen Steuergeräten für Kraftfahrzeugmotoren, in der Luftfahrt- oder der Raumfahrttechnik), muss das aus Leiterplatte und Kühlkörperteil bestehende Verbundteil verschiedene, zum Teil gegensätzliche Anforderungen erfüllen.

So muss einerseits eine feste, über viele Jahre zuverlässig haltende Verbindung zwischen Kühlkörperteil und Leiterplatte gewährleistet sein, andrerseits dürfen die durch die Temperaturänderungen hervorgerufenen, aufgrund der verwendeten Materialien mit unterschiedlichen Wärmeausdehnungskoeffizienten verschiedenen thermischen Ausdehnungen keine wesentlichen mechanischen Kräfte oder Spannungen auf die Leiterplatten und die elektronischen Bauelemente übertragen, da sonst die Bauelemente selbst oder die Lotstellen auf den Leiterplatten beschädigt werden könnten. Selbst wenn solche sogenannten Dilatationsspannungen nicht direkt elektrische Leitungsunterbrüche bei den Lotstellen bewirken, können die Spannungen Risse in den Lotstellen verursachen, welche dann bei Anwendungen z.B. in Kraftfahrzeugmotoren, wo die Leiterplatten zusätzlich zu den thermischen Schwankungen noch beträchtlichen Vibrationen ausgesetzt sind, eine erhöhte Ausfallhäufigkeit der Leiterplatten zur Folge haben.

Als weiteres Erfordernis muss die Verbindung zwischen der Leiterplatte und dem Kühlkörperteil einerseits eine gute Wärmeübertragung und andrerseits eine hohe elektrische Isolation zwischen der Leiterplatte und dem Kühlkörperteil gewährleisten.

Bisherige mit Kühlkörpern versehene Leiterplatten vermögen die hohen Anforderungen bezüglich elektrischem Isolationsvermögen und Wärmeleitfähigkeit zwischen Leiterplatte und Kühlkörper, Vibrationsfestigkeit, Unempfindlichkeit gegen Temperaturänderungen und Langlebigkeit, wie sie für den Einsatz von Leiterplatten in Kraftfahrzeugmotoren zu erfüllen sind, nicht in gewünschtem Ausmass zu erfüllen.

### Darstellung der Erfindung

Der Erfindung liegt die Aufgabe zugrunde, eine mit Kühlkörpern oder Kühlplatten versehene Leiterplatte bereit zu stellen, welche hohe Anforderungen bezüglich elektrischem Isolationsvermögen und Wärmeleitfähigkeit zwischen Leiterplatte und Kühlkörper, Vibrationsfestigkeit, Unempfindlichkeit gegen Temperaturänderungen und Langlebigkeit erfüllt, damit sie insbesondere für Anwendungen in Kraftfahrzeugmotoren verwendbar ist.

Die Lösung der Aufgabe ist Gegenstand der unabhängigen Patentansprüche 1, 7 und 8.

Gemäss der Erfindung weist ein Verfahren zum Herstellen einer mit mindestens einem Kühlkörperteil versehenen Leiterplatte die folgenden Schritte auf: ein dauerelastischer Haftkleber wird auf eine Klebfläche eines ersten Teiles des Teilepaares bestehend aus der Leiterplatte und dem mindestens einen mit dieser zu verbindenden Kühlkörperteil aufgetragen; zur Elimination von allfällig im Kleber und/oder zwischen dem Kleber und der Klebfläche vorhandenen Luftblasen wird das erste Teil mitsamt dem aufgetragenen Kleber getempert; die Verbindung zwischen den beiden zu verbindenden Teilen des Teilepaares wird hergestellt, indem die Klebfläche des ersten Teiles, auf welche der Haftkleber aufgetragen wurde, und die Klebfläche des zweiten Teiles aneinandergedrückt werden.

Eine erfindungsgemässe Leiterplatte weist mindestens ein Kühlkörperteil auf, wobei die Leiterplatte durch einen dauerelastischen Haftkleber mit dem Kühlkörperteil verbunden ist.

Eine erfindungsgemässe Anordnung zur Durchführung des Verfahrens zum Herstellen einer mit mindestens einem Kühlkörperteil versehenen Leiterplatte umfasst eine Auftragungsvorrichtung zum Auftragen eines dauerelastischer Haftklebers auf eine Klebfläche eines ersten Teiles eines Teilepaares, das aus der Leiterplatte und dem mit dieser zu verbindenden Kühlkörperteil besteht. Die Anordnung umfasst weiter einen Ofen zum Tempern des ersten Teiles mitsamt dem aufgetragenen Kleber, wodurch allfällig im Kleber und/oder zwischen dem Kleber und der Klebfläche vorhandenen Luftblasen eliminiert werden, und eine Andrückvorrichtung zum Aneinanderdrücken der Klebflächen der beiden Teile des Teilepaares.

Als Klebflächen werden in der vorliegenden Beschreibung, der Zusammenfassung und den Patentansprüchen die zu verklebende Flächen von mittels Klebstoff zu verbindenden Körpern bezeichnet.

Die Verwendung eines dauerelastischen Haftklebers liefert eine elastische, Dilatationsspannungen im wesentlichen eliminierende Verbindung zwischen der Leiterplatte und der Kühlplatte bzw. dem Kühlkörper. Solche Kleber werden auch als Dilatationskleber oder dilatationsfähige Klebstoffe bezeichnet. Im Gegensatz dazu liefern die üblicherweise zum Verbinden von Leiterplatten mit Kühlplatten verwendeten heisshärtenden Klebstoffe zwar eine stark haftende, aber zugleich harte, unelastische und Dilatationsspannungen auf die Leiterplatte übertragende Verbindung.

Bisher wurden die im Vergleich zu heisshärtenden Klebstoffen geringere Haftkraft und die häufig kleinere Wärmeleitfähigkeit als kleberinhärente Nachteile von kaltklebenden, dauerelastischen Haftklebern (auch Kaltkleber genannt) betrachtet. Durch das Verfahren gemäss der Erfindung werden diese Nachteile von Kaltklebern wesentlich vermindert. Indem durch den erfindungsgemässen Schritt des Temperns des kaltklebenden Haftklebers allfällig im Kleber und/oder zwischen dem Kleber und der Klebfläche vorhandene Luftblasen zum Verschwinden gebracht werden, wird eine wesentliche Ursache für die Verminderung der Haftkraft und der Wärmeleitfähigkeit des Kaltklebers eliminiert.

Für das erfindungsgemässe Verfahren wird ein dauerelastischer Haftkleber verwendet, der sich weiter durch eine gute elektrische Isolationsfähigkeit, eine gute Wärmeleitfähigkeit und eine lange Dauerhaftigkeit auszeichnet.

Durch die Erfindung wird somit eine mit einem Kühlkörper versehene Leiterplatte geschaffen, welche hohe Anforderungen bezüglich elektrischem Isolationsvermögen und Wärmeübertragung zwischen Leiterplatte und Kühlkörper, Vibrationsfestigkeit, Dilatationsfestigkeit und Langlebigkeit erfüllt und somit insbesondere für Anwendungen in Kraftfahrzeugmotoren geeignet ist.

Vorzugsweise wird als Haftkleber für die Verbindung zwischen der Leiterplatte und dem mindestens einen Kühlkörperteil ein trocken übertragbarer Klebstofffilm verwendet. Dieser Klebstofffilm kann mit beidseitigen Schutzfolien versehen sein.

Bei einem für diese Ausführungsart der Erfindung bevorzugten Verfahren weist der Schritt des Auftragens des Klebers die Teilschritte auf, das erste Teil so auf einer ersten Arbeitsfläche einer Auftragungsvorrichtung zu positionieren, dass seine Klebfläche freiliegt, den mit beidseitigen Schutzfolien versehene Klebstofffilm so auf einer zweiten Arbeitsfläche der Auftragungsvorrichtung zu positionieren, dass eine Seite des Films freiliegt, die Schutzfolie auf der freiliegenden Seite des Klebstofffilms abzuziehen und den Klebstofffilm auf die Klebfläche des ersten Teiles aufzutragen, indem die freiliegende Seite des Klebstofffilms und die freiliegende Klebfläche des ersten Teiles mittels der Auftragungsvorrichtung aneinandergedrückt werden. Der Schritt des Verbindens der Teile des Teilepaares umfasst bei diesem bevorzugten Verfahren die Teilschritte, das erste Teil so auf einer ersten Arbeitsfläche einer Andrückvorrichtung zu Positionieren, dass seine Klebfläche, auf welcher der Klebstofffilm aufgetragen ist, freiliegt, die Schutzfolie auf der freiliegenden Seite des Klebstofffilms abzuziehen; das zweite Teil des Teilepaares so auf einer zweiten Arbeitsfläche der Andrückvorrichtung zu positionieren, dass seine Klebfläche freiliegt, und die beiden Teile miteinander zu verbinden, indem ihre freiliegenden Klebflächen mittels der Andrückvorrichtung aneinandergedrückt werden.

Beim erfindungsgemässen Verfahren wird vorzugsweise zur Verminderung der Bildung von Luftblasen zwischen dem Klebstofffilm und der Klebfläche des ersten Teiles der Klebstofffilm in einem abrollenden Vorgang derart auf die Klebfläche des ersten Teiles aufgetragen, dass das Auftragen stets linienförmig, aber nie flächenförmig, erfolgt.

Vorzugsweise wird nach dem Aneinanderdrücken der Teile ein weiterer Schritt des Temperns ausgeführt, in welchem das die Leiterplatte, das Kühlkörperteil und den Haftkleber umfassende Verbundteil getempert wird, um den auf das Aneinanderdrücken folgenden Angleichungsvorgang zwischen dem Kleber und den Klebflächen zu beschleunigen.

Bei einer bevorzugten Anordnung zum Durchführen des erfindungsgemässen Verfahrens umfasst die Auftragungsvorrichtung eine wippenartige Vorrichtung. Diese hat eine im wesentlichen ebene erste Arbeitsfläche, auf welcher das erste Teil so positionierbar ist, dass seine Klebfläche freiliegt, und eine konvex gekrümmte zweite Arbeitsfläche, auf welcher der Haftkleber anbringbar ist. Zum Auftragen des Klebers auf die Klebfläche sind die beiden Arbeitsflächen in einem Abrollvorgang nach Art einer Wippe derart gegeneinander abrollbar, dass in jedem Zeitpunkt des Abrollvorgangs der Haftkleber linienförmig, aber nie flächenförmig, auf die Klebfläche aufgetragen wird.

Die nachfolgende detaillierte Beschreibung der vorliegenden Erfindung dient in Verbindung mit den beiliegenden Zeichnungen nur als Beispiel für ein besseres Verständnis der Erfindung und ist nicht als Einschränkung des Schutzbereichs der Patentansprüche aufzufassen. Für den Fachmann sind aus der nachfolgenden Beschreibung in Verbindung mit den beiliegenden Zeichnungen und der Gesamtheit der Patentansprüche weitere vorteilhafte Ausführungsformen und Merkmalskombinationen ohne weiteres erkennbar, die jedoch immer noch innerhalb des Bereichs der vorliegenden Erfindung liegen.

### Kurze Beschreibung der Zeichnungen

Die Zeichnungen stellen eine bevorzugte Ausführungsform der vorliegenden Erfindung dar. Es zeigen:
- Fig. 1: eine schematische Darstellung des Ablaufs eines Verfahrens gemäss einer bevorzugten Ausführungsart der Erfindung;
- Fig. 2: eine Seitenansicht eines Teils einer mit einem Kühlkörperteil versehenen Leiterplatte gemäss einer Ausführungsart der Erfindung;
- Fig. 3: eine Teilansicht einer Anordnung zur Durchführung des erfindungsgemässen Verfahrens.

Grundsätzlich sind in den Figuren gleiche Teile mit gleichen Bezugszeichen versehen.

### Wege zur Ausführung der Erfindung

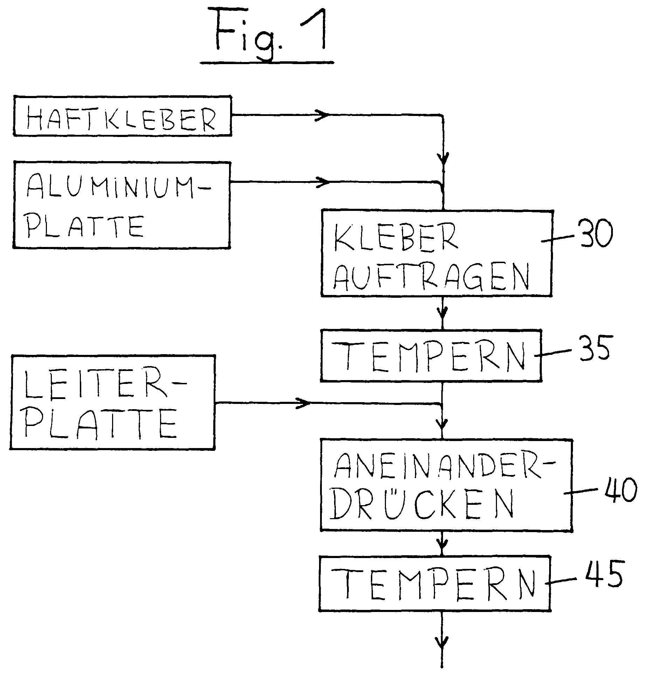

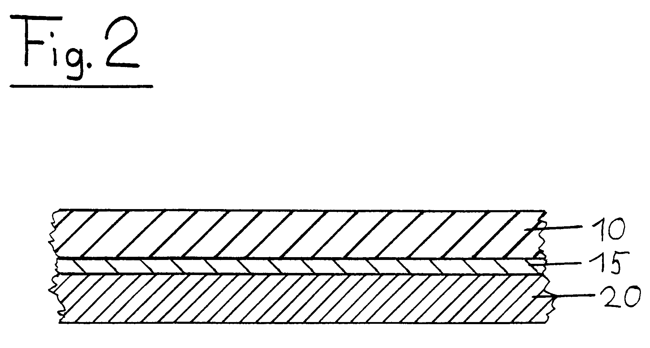

Figur 1 stellt schematisch den Ablauf eines Verfahrens zum Herstellen einer mit einem Kühlkörperteil 20 versehenen Leiterplatte 10 gemäss einer bevorzugten Ausführungsart der Erfindung dar. Eine Seitenansicht eines Teils der mit dem Kühlkörperteil 20 versehenen Leiterplatte 10 gemäss einer Ausführungsart der Erfindung ist in Figur 2 dargestellt.

Die in Figur 2 dargestellte Leiterplatte 10 ist mit einem flachen Kühlkörperteil in Form einer Kühlplatte 20 versehen. Die Leiterplatte 10 gemäss diesem Ausführungsbeispiel hat eine im wesentlichen rechteckige Form, und die Kühlplatte 20 hat eine im wesentlichen der Leiterplatte entsprechende Form. Grundsätzlich können sowohl Leiterplatte als auch Kühlplatte auch andere Formen haben, wobei die Form der Kühlplatte jener der Leiterplatte nicht notwendigerweise entsprechen muss. Es können auch mehrere Kühlkörper für eine Leiterplatte und/oder mehrere Leiterplatten für einen Kühlkörper vorgesehen sein. Die in Figur 2 dargestellte Kühlplatte 20 besteht im wesentlichen aus Aluminium, wobei ihre leiterplattenseitige Oberfläche zur Bildung einer wärmeleitenden, elektrisch isolierenden Oxid-Schicht auf der Aluminiumplatte 20 eloxiert sein kann. Die Kühlplatte könnte jedoch ebensogut aus Kupfer oder irgend einem anderen für Kühlkörper geeigneten Material bestehen.

Gemäss dem in Figur 1 dargestellten Verfahren wird in einem ersten Schritt 30 ein dauerelastischer Haftkleber oder Haftklebstoff 15 auf die Klebfläche der Kühlplatte 20 aufgetragen. Der Haftkleber gemäss der dargestellten Ausführungsform der Erfindung besteht aus einem beidseitig mit Schutzfolien versehenen, trocken übertragbaren Klebstofffilm, wie er z.B. von der Firma 3M unter dem Markennamen "Isotac" vertrieben wird.

Zunächst wird das erste Teil des Teilepaares bestehend aus der Leiterplatte 10 und der Kühlplatte 20 - beim dargestellten Verfahren die Kühlplatte 20 - so auf einer ersten Arbeitsfläche 55 einer Auftragungsvorrichtung 50 positioniert, dass seine Klebfläche freiliegt. Die Arbeitsfläche 55 befindet sich an einer im wesentlichen ebenen Trägerplatte 80 der Auftragungsvorrichtung 50. Zu diesem Zeitpunkt des Verfahrens ist die Trägerplatte 80 aufgeklappt, so dass die Arbeitsfläche 55 auf der Oberseite der Trägerplatte 80 liegt.

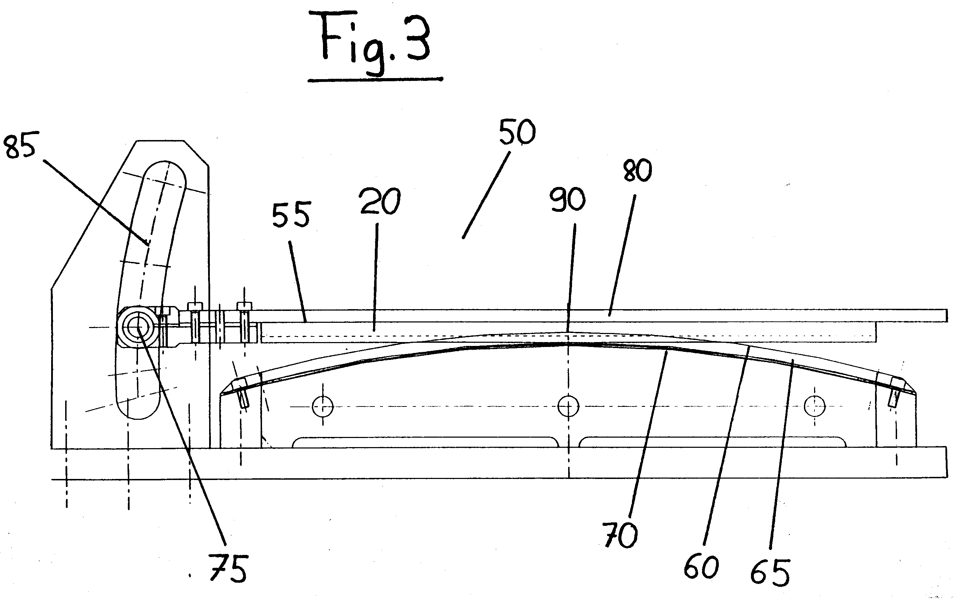

Eine Auftragungsvorrichtung 50 gemäss einer bevorzugten Ausführungsart der erfindungsgemässen Anordnung zum Durchführen des Verfahrens ist in Figur 3 in Seitenansicht dargestellt.

Anschliessend wird der mit beidseitigen Schutzfolien versehene Klebstofffilm 15 so auf einer zweiten Arbeitsfläche 60 der Auftragungsvorrichtung 50 positioniert, dass eine Seite des Films freiliegt. Die zweite Arbeitsfläche 60 der dargestellten Auftragungsvorrichtung 50 besteht aus einer weichen Schicht 65 aus Moosgummi, die auf einer festen, konvex gekrümmten Trägerplatte 70 angeordnet ist. Sowohl die Kühlplatte 20 als auch der Klebstofffilm 15 werden dann auf ihren entsprechenden Arbeitsflächen 55, 60 vorübergehend fixiert. Zur wieder lösbaren Fixierung können doppelseitige Klebstreifen, Vakuumvorrichtungen in den Arbeitsflächen oder andere geeignete Vorrichtungen für eine einfach einzurichtende und wieder lösbare Befestigung verwendet werden.

Nach der Fixierung des Klebstofffilms 15 auf der Arbeitsfläche 60 wird die kühlplattenseitige Schutzfolie des Klebstofffilms entfernt.

Dann wird die Trägerplatte 70 mit der Kühlplatte 20 um das Drehgelenk 75 umgeklappt, so dass die Klebfläche der Kühlplatte 20 nun im wesentlichen gegenüber der freiliegenden Seite des Klebstofffilms 15 auf der Arbeitsfläche 60 angeordnet ist. Die Kühlplatte liegt nun auf der Unterseite der Trägerplatte 80, wie es in Figur 3 dargestellt ist, und die Auftragungsvorrichtung 50 stellt jetzt insgesamt eine wippenartige Vorrichtung dar. Nun wird die Kühlplatte 20 in einem abrollenden Vorgang nach Art einer Wippe über die freiliegende Oberseite des Klebstofffilms 15 auf der konvex gekrümmte Arbeitsfläche 60 von einem Ende bis zum gegenüberliegenden Ende abgerollt, wobei der Abrollvorgang durch eine Kurvenführungsvorrichtung 85, welche die Bewegung der Trägerplatte 80 führt, gesteuert wird. Gleichzeitig wird die Fixierung zwischen dem Klebstofffilm 15 und der Arbeitsfläche 60 gelöst (der Klebstofffilm 15 ist zu diesem Zeitpunkt auf seiner arbeitsflächenseitigen Oberfläche noch immer mit einer Schutzfolie versehen). Durch die abrollende Bewegung von einem Ende der Klebfläche auf der Kühlplatte 20 zum gegenüberliegenden Ende wird der Klebstofffilm 15 derart auf die Klebfläche der Kühlplatte 20 aufgetragen, dass in jedem Zeitpunkt das Auftragen stets linienförmig, aber nie flächenförmig, erfolgt. Dadurch wird die Bildung von Luftblasen zwischen dem Klebstofffilm 15 und der Klebfläche der Kühlplatte 20 wirksam verhindert. Anschliessend wird die Kühlplatte 20 mit auf ihre Klebfläche aufgetragenem Klebstofffilm 15 von der Auftragungsvorrichtung 20 gelöst.

In einem zweiten Schritt 35 gemäss dem in Figur 1 dargestellten Verfahren wird die Kühlplatte 20 mitsamt dem aufgetragenen Haftkleber 15 in einem Ofen getempert. Zum Tempern wird die Kühlplatte 20 mit dem Klebstofffilm 15 während einer vorgegebenen Verweilzeit bei einer bestimmten Temperatur im Ofen belassen. Die Verweilzeit liegt in einem Bereich von einigen Minuten bis mehreren Stunden und beträgt vorzugsweise ungefähr eine Stunde, dies bei einer Ofentemperatur im Bereich zwischen 30 °C und 150 °C, vorzugsweise ungefähr 50 °C. Durch das Tempern werden allfällig im Klebstofffilm 15 und/oder zwischen dem Klebstofffilm 15 und der Klebfläche der Kühlplatte 20 vorhandene Luftblasen zum Verschwinden gebracht. Nach dem Tempern wird die Kühlplatte 20 mitsamt dem aufgetragenen Haftkleber 15 aus dem Ofen entnommen.

Anschliessend wird in einem dritten Schritt 40 gemäss dem in Figur 1 dargestellten Verfahren die Verbindung zwischen den der Kühlplatte 20 und der Leiterplatte 10 hergestellt. Dazu wird zunächst die noch auf der leiterplattenseitigen Oberfläche des Klebstofffilms 15 vorhandene Schutzfolie vom Klebstofffilm 15 abgezogen. Dann werden die Kühlplatte 20 und die Leiterplatte 10 so nebeneinander positioniert, dass sie je mit einer Randkante auf einer gemeinsamen Linie angeordnet sind, ihre Ebenen unter einem Winkel zueinander angeordnet sind und die Klebfläche der Leiterplatte gegen die nun freiliegende Oberfläche des Klebstofffilms 15 auf der Klebfläche der Kühlplatte 20 gerichtet ist. Die Anordnung der Leiterplatte 10 bezüglich der Kühlplatte 20 entspricht nun ungefähr derjenigen eines aufgeklappten Buchdeckels bezüglich des zugehörigen Buches. Nun wird die Leiterplatte 10 um die Linie, auf welcher die Kanten der Leiterplatte 10 und der Kühlplatte 20 angeordnet sind, auf den Klebstofffilm 15 auf der Klebfläche der Kühlplatte 20 umgeklappt, auf ähnliche Weise wie der Buchdeckel auf das zugehörige Buch zugeklappt wird. Danach werden die Leiterplatte 10 und die Kühlplatte 20 in einer Andrückvorrichtung (nicht dargestellt) aneinandergedrückt. Durch die Klappbewegung erfolgt die Verklebung zwischen Leiterplatte 10 und Kühlplatte 20 quasi linienförmig, nicht flächenförmig. Dadurch wird die Bildung von Luftblasen zwischen dem Klebstofffilm 15 und der Klebfläche der Leiterplatte 10 wirksam verhindert.

In einem vierten Schritt 45 gemäss dem in Figur 1 dargestellten Verfahren wird ein weiterer Schritt des Temperns ausgeführt. Das Tempern des Verbundteiles bestehend aus der Leiterplatte 10, der Kühlplatte 20 und dem Klebstofffilm 15 dient der Beschleunigung des Angleichungsvorgang zwischen dem elastischen Haftkleber und den Klebflächen.

Zusammenfassend ist festzustellen, dass durch die Erfindung ein Verfahren zum Herstellen einer mit einem Kühlkörperteil versehenen Leiterplatte, eine nach einem solchen Verfahren hergestellte Leiterplatte sowie eine Anordnung zum Durchführen des Verfahrens bereit gestellt wird, wobei die Leiterplatte hohe Anforderungen bezüglich elektrischem Isolationsvermögen und Wärmeübertragung zwischen der Leiterplatte und dem Kühlkörperteil, Vibrationsfestigkeit, Dilatationsfestigkeit und Langlebigkeit erfüllt und somit insbesondere für Anwendungen in Kraftfahrzeugmotoren geeignet ist.

## Patentansprüche

1. Verfahren zum Herstellen einer mit mindestens einem Kühlkörperteil (20) versehenen Leiterplatte (10), das die folgenden Schritte (30, 35, 40) aufweist:
• ein dauerelastischer Haftkleber (15) wird auf eine Klebfläche eines ersten Teiles des Teilepaares bestehend aus der Leiterplatte (10) und dem mindestens einen mit dieser zu verbindenden Kühlkörperteil (20) aufgetragen (30);
• zur Elimination von allfällig im Kleber (15) und/oder zwischen dem Kleber (15) und der Klebfläche vorhandenen Luftblasen wird das erste Teil mitsamt dem aufgetragenen Kleber (15) getempert (35);
• die Verbindung zwischen den beiden zu verbindenden Teilen des Teilepaares wird hergestellt, indem die Klebfläche des ersten Teiles und die Klebfläche des zweiten Teiles aneinandergedrückt (40) werden.

2. Verfahren nach Anspruch 1, dadurch gekennzeichnet, dass als Haftkleber für die Verbindung zwischen der Leiterplatte (10) und dem mindestens einen Kühlkörperteil (20) ein trocken übertragbarer Klebstofffilm (15) verwendet wird.

3. Verfahren nach Anspruch 2, dadurch gekennzeichnet, dass ein mit beidseitigen Schutzfolien versehener Klebstofffilm (15) als Haftkleber verwendet wird.

4. Verfahren nach Anspruch 3, dadurch gekennzeichnet, dass der Schritt (30) des Auftragens des Klebers die folgenden Teilschritte aufweist:
• das erste Teil wird so auf einer ersten Arbeitsfläche (55) einer Auftragungsvorrichtung (50) positioniert, dass seine Klebfläche freiliegt;
• der mit beidseitigen Schutzfolien versehene Klebstofffilm (15) wird so auf einer zweiten Arbeitsfläche (60) der Auftragungsvorrichtung (50) positioniert, dass eine Seite des Films freiliegt;
• die Schutzfolie auf der freiliegenden Seite des Klebstofffilms (15) wird abgezogen;
• der Klebstofffilm (15) wird auf die Klebfläche des ersten Teiles aufgetragen, indem die freiliegende Seite des Klebstofffilms (15) und die freiliegende Klebfläche des ersten Teiles mittels der Auftragungsvorrichtung (50) aneinandergedrückt werden;
und dass der Schritt (40) des Verbindens der Teile des Teilepaares die folgenden Teilschritte umfasst:
• das erste Teil wird so auf einer ersten Arbeitsfläche einer Andrückvorrichtung positioniert, dass seine Klebfläche, auf welcher der Klebstofffilm (15) aufgetragen ist, freiliegt;
• die Schutzfolie auf der freiliegenden Seite des Klebstofffilms (15) wird abgezogen;
• das zweite Teil des Teilepaares wird so auf einer zweiten Arbeitsfläche der Andrückvorrichtung positioniert, dass seine Klebfläche freiliegt;
• die beiden Teile werden miteinander verbunden, indem ihre freiliegenden Klebflächen mittels der Andrückvorrichtung aneinandergedrückt werden.

5. Verfahren nach einem der Ansprüche 2 bis 4, dadurch gekennzeichnet, dass zur Verminderung der Bildung von Luftblasen zwischen dem Klebstofffilm (15) und der Klebfläche des ersten Teiles der Klebstofffilm (15) in einem abrollenden Vorgang derart auf die Klebfläche des ersten Teiles aufgetragen (30) wird, dass in jedem Zeitpunkt das Auftragen stets linienförmig, aber nie flächenförmig, erfolgt.

6. Verfahren nach einem der Ansprüche 1 bis 5, dadurch gekennzeichnet, dass nach dem Aneinanderdrücken (40) der Teile ein weiterer Schritt (45) des Temperns ausgeführt wird, in welchem das die Leiterplatte (10), das Kühlkörperteil (20) und den Haftkleber (15) umfassende Verbundteil getempert wird, um den auf das Aneinanderdrücken (40) folgenden Angleichungsvorgang zwischen dem Kleber (15) und den Klebflächen zu beschleunigen.

7. Leiterplatte (10) mit mindestens einem Kühlkörperteil (20), hergestellt nach dem Verfahren gemäss einem der Ansprüche 1 bis 6, wobei die Leiterplatte (10) durch einen dauerelastischen Haftkleber (15) mit dem Kühlkörperteil (20) verbunden ist.

8. Anordnung zur Durchführung des Verfahrens gemäss einem der Ansprüche 1 bis 6, gekennzeichnet durch eine Auftragungsvorrichtung (50) zum Auftragen (30) eines dauerelastischer Haftklebers (15) auf eine Klebfläche eines ersten Teiles eines Teile paares bestehend aus einer Leiterplatte (10) und einem mit dieser zu verbindenden Kühlkörperteil (20), einen Ofen zum Tempern (35) des ersten Teiles mitsamt dem aufgetragenen Kleber (15) zum Zwecke der Elimination von allfällig im Kleber (15) und/oder zwischen dem Kleber (15) und der Klebfläche vorhandenen Luftblasen und eine Andrückvorrichtung zum Aneinanderdrücken (40) der Klebflächen der beiden Teile des Teilepaares.

9. Anordnung nach Anspruch 8, dadurch gekennzeichnet, dass die Auftragungsvorrichtung (50) eine wippenartige Vorrichtung umfasst mit einer im wesentlichen ebenen ersten Arbeitsfläche (55), auf welcher das erste Teil so positionierbar ist, dass seine Klebfläche freiliegt, und einer konvex gekrümmten zweiten Arbeitsfläche (60), auf welcher der Haftkleber (15) anbringbar ist, wobei zum Auftragen (30) des Klebers (15) auf die Klebfläche die beiden Arbeitsflächen (55, 60) in einem Abrollvorgang nach Art einer Wippe derart gegeneinander abrollbar sind, dass in jedem Zeitpunkt des Abrollvorgangs der Haftkleber (15) stets linienförmig, aber nie flächenförmig, auf die Klebfläche aufgetragen wird.
